Europäisches Patentamt

(19) European Patent Office

Office européen des brevets

(11) Numéro de publication: **0 055 154
B1**

(12) **FASCICULE DE BREVET EUROPEEN**

(45) Date de publication du fascicule du brevet:
08.01.86

(21) Numéro de dépôt: **81401871.9**

(22) Date de dépôt: **25.11.81**

(51) Int. Cl.⁴: **B 41 F 15/36, H 05 K 13/00**

(54) Dispositif de positionnement et de blocage d'un porte-écran dans une machine de sérigraphie destinée notamment à la fabrication de supports de circuits de connexions à couches épaisses.

(30) Priorité: **24.12.80 FR 8027418**

(43) Date de publication de la demande:
**30.06.82 Bulletin 82/26**

(45) Mention de la délivrance du brevet:
**08.01.86 Bulletin 86/2**

(84) Etats contractants désignés:
**CH DE FR GB IT LI NL SE**

(56) Documents cités:
**IBM TECHNICAL DISCLOSURE BULLETIN, vol. 13, no. 10, mars 1971 NEW YORK (US) T.W. LEVERETT et al.: Semiconductor Wafer Aligner" pages 2983-2984
IBM TECHNICAL DISCLOSURE BULLETIN, vol. 18, no. 3, août 1975 NEW YORK (US) M.R. BAKER et al.: "Semiconductor Wafer-to-Frame Aligner" pages 811-812**

(73) Titulaire: **CII HONEYWELL BULL, 94 Avenue Gambetta P.C. OW009, F-75020 Paris (FR)**

(72) Inventeur: **Colineau, Robert, Constant, 94 avenue Gambetta, F-75020 Paris (FR)**

(74) Mandataire: **Denis, Hervé, 94, avenue Gambetta, F-75020 Paris (FR)**

ACTORUM AG

### Description

La présente invention concerne généralement une machine de sérigraphie, et a plus particulièrement pour objet un dispositif de positionnement et de blocage d'un porte-écran dans une machine de sérigraphie destinée notamment à la fabrication de supports de circuits de connexions à couches épaisses dénommés ci-après «substrats».

Dans le but de réaliser des circuits encore plus performants et de les rassembler dans un volume toujours plus réduit, les constructeurs ont été conduits à utiliser des micro-plaquettes de circuits intégrés, désignées communément sous le nom de «puces» («chips» en anglais) et à les monter sur des substrats dont les conducteurs sont répartis en plusieurs plans séparés les uns des autres par des couches isolantes, sauf en certains points déterminés où des colonnes conductrices assurent des liaisons électriques entre des conducteurs situés dans des plans différents.

La fabrication de ces substrats est généralement réalisée à l'aide d'une machine de sérigraphie qui permet de déposer sur un support électriquement isolant, par exemple en alumine, une série de couches alternativement conductrices et isolantes, chaque couche étant obtenue par application, au travers d'un écran dont le motif transparent correspond à celui de la couche à réaliser, d'une matière pâteuse qui est soit conductrice, soit isolante. Le substrat est, après chaque application d'une couche, retiré de la machine de sérigraphie pour être placé dans un four à température élevée qui permet à cette couche de se solidifier pour former une couche à caractère métallique ou isolant qui adhère fortement sur le support ou sur la couche précédente.

Afin de pouvoir réaliser des connexions électriques entre des conducteurs situés dans des plans différents, il est indispensable que, non seulement les écrans qui sont montés successivement dans la machine de sérigraphie pour déposer ces couches soient positionnés avec une très grande précision les uns par rapport aux autres, mais également que le substrat qui est mis à chaque fois en place dans la machine de sérigraphie pour recevoir une couche soit également positionné avec précision par rapport à l'écran.

De façon générale, l'écran est porté par un porte-écran positionné et maintenu en position dans la machine de sérigraphie par l'intermédiaire d'un dispositif de positionnement et de blocage. Une telle machine de sérigraphie est notamment décrite dans le brevet français n° 2 445 226 de la demanderesse. Ce brevet décrit, en commun avec la machine conforme à l'invention, une machine de sérigraphie pour la fabrication de supports de circuits de connexions à couches épaisses, comprenant: un bâti; un porte-écran fait de quatre montants, dont deux montants latéraux parallèles, formant un cadre délimitant une ouverture; un écran rapporté sur une face du porte-écran en recouvrement de son ouverture; un dispositif de positionnement du porte-écran par rapport au bâti, incluant deux pions de référence fixes et verticaux, solidaires du bâti et coopérant avec deux cavités correspondantes du porte-écran; et un dispositif de blocage en position finale du porte-écran dans la machine.

Cependant, il est important de noter que les deux cavités du porte-écran de cette machine sont deux alésages épousant au plus juste la forme des pions de référence. Ainsi le positionnement du porte-écran dans la machine de sérigraphie s'effectue en déplaçant le porte-écran suivant une direction perpendiculaire à son plan pour l'amener depuis une position inférieure jusqu'à une position supérieure où les pions de référence se retrouvent enfichés dans les alésages correspondants du porte-écran. Dans une machine de sérigraphie mise au point par la demanderesse, le porte-écran est placé sur une table mobile suivant un axe vertical et dont le déplacement est commandé par un vérin par exemple. Le porte-écran est mis en place par des colonnes verticales amovibles qui n'assurent qu'un centrage approximatif du porte-écran. Le blocage en position finale du porte-écran dans la machine s'effectue par de simples vis prenant appui sur le bâti.

La précision du positionnement du porte-écran dans la machine de sérigraphie est ainsi obtenue par la précision de l'usinage des pions de référence et des alésages, usinage effectué à quelques microns près. Autrement dit, la précision du positionnement du porte-écran ne peut être obtenue qu'à la seule condition qu'il y ait un jeu minimum entre chaque pion de référence et l'alésage correspondant du porte-écran. Du fait de l'imprécision du montage du porte-écran, la coopération répétée entre les pions de référence et les alésages du porte-écran entraîne une usure progressive et inévitable de ces derniers, usure qui modifie par conséquent la précision du positionnement du porte-écran dans la machine de sérigraphie. Enfin, il est à noter que le montage du porte-écran nécessite l'utilisation de colonnes de montage qui alourdissent la structure de la machine de sérigraphie.

L'invention vise à pallier l'usure provoquée par la coopération répétée entre les pions de référence et les alésages du porte-écran, et à supprimer l'utilisation de colonnes de support pour la mise en place du porte-écran dans la machine de sérigraphie.

Il est utilisé pour cela un dispositif de positionnement qui s'inspire de celui décrit dans l'article de Baker et al aux pages 811 et 812 de la revue IBM Technical Disclosure Bulletin, vol. 18, n° 33, août 1975. Dans ce dispositif, un cadre est introduit dans deux glissières horizontales, parallèles à deux montants latéraux du cadre et est positionné grâce à deux pions de référence fixes et verticaux, destinés à coopérer respectivement avec une face droite et une face en V de deux butées du cadre. Ce dispositif convient pour un cadre employé pour supporter une tranche de silicium. Un tel cadre a de petites dimensions (10 cm environ), est très mince et très léger. Cependant, l'emploi de ce dispositif de positionnement antérieur pour un porte-écran de grandes dimensions, épais et lourd, avec la grande précision précitée, requise pour la fabrication de substrats pour circuits intégrés, poserait de grandes difficultés à la fois pour la réalisation des glissières et du porte-écran, pour la manipulation du porte-écran, pour son introduction sans heurt dans les glissières et pour son positionnement sûr et précis contre les pions de référence.

L'invention remédie à ces inconvénients.

L'invention se rapporte à une machine de sérigraphie pour la fabrication de supports de circuits de connexions à couches épaisses, comprenant: un bâti; un porte-écran fait de quatre montants, dont deux montants latéraux parallèles, formant un cadre délimitant une ouverture; un écran rapporté sur une face du porte-écran en recouvrement de l'ouverture; un dispositif de positionnement du porte-écran par rapport au bâti, incluant deux pions de référence fixes et verticaux, solidaires du bâti et coopérant avec deux cavités correspondantes du porte-écran; et un dispositif de blocage en position finale du porte-écran dans la machine; caractérisé en ce que dans le dispositif de positionnement: deux glissières horizontales, portées par le bâti et parallèles aux deux montants latéraux, forment un support coulissant pour ces deux montants pour introduire le porte-écran dans la machine; les deux cavités sont deux rainures parallèles, usinées respectivement dans les deux montants latéraux du porte-écran parallèlement à ces deux montants et débouchant d'un même côté du porte-écran; les deux pions de référence ont un diamètre sensiblement inférieur à la largeur des rainures, pénètrent progressivement à l'intérieur des deux rainures respectives et sont décalés dans la direction des montants latéraux de façon que l'une des rainures puis les deux rainures servent de guidage pour l'introduction du porte-écran; et deux butées, l'une à face droite et l'autre à face en V, sont montées dans les deux rainures en étant décalées à l'égal des deux pions pour le positionnement final du porte-écran dans la machine.

Les caractéristiques et avantages de l'invention ressortiront de la description qui va suivre faite en référence aux dessins annexés, dans lesquels:

- la figure 1 est une vue en plan d'un porte-écran pour illustrer la partie du dispositif de positionnement et de blocage conforme à l'invention située au niveau du porte-écran,

- la figure 2 est une vue en coupe suivant la ligne II-II de la figure 1 avec l'écran rapporté sur le porte-écran,

- la figure 3 est une vue en coupe partielle agrandie suivant la ligne III-III de la figure 1,

- la figure 4 est une vue en coupe partielle agrandie suivant la ligne IV-IV de la figure 1,

- la figure 5 est une vue en élévation schématique d'une machine de sérigraphie pour illustrer la partie du dispositif de positionnement et de blocage du porte-écran conforme à l'invention située au niveau de cette machine; et

- la figure 6 est une vue agrandie du détail indiqué par la flèche VI de la figure 5.

Avant de décrire le dispositif de positionnement et de blocage d'un porte-écran conforme à l'invention, il est nécessaire de définir au préalable la structure générale d'un porte-écran 10 destiné à être introduit dans une machine de sérigraphie pour la fabrication de circuits de connexions à couches épaisses multiples.

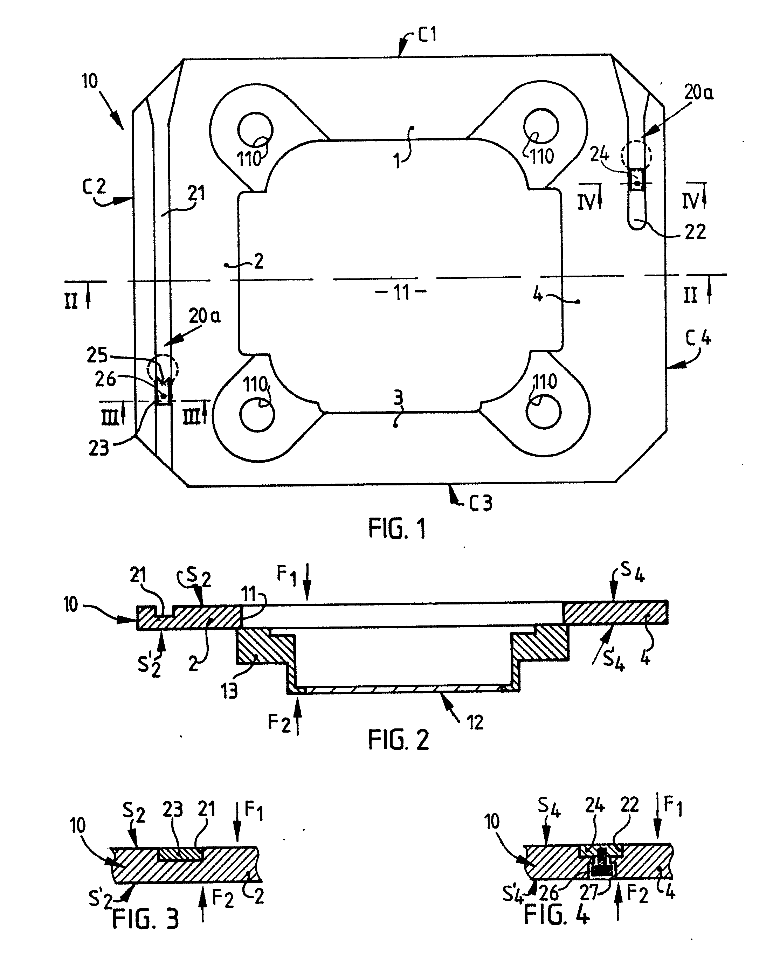

En se référant aux figures 1 à 4, le porte-écran 10 se présente sous la forme d'un cadre à quatre côtés principaux C1, C2, C3, C4 délimitant entre eux une ouverture 11 qui débouche sur les deux faces opposées principales F1 et F2 du porte-écran 10. Les quatre côtés du porte-écran 10 sont par exemple délimités par quatre montants, 1, 2, 3, 4 respectivement.

Pour entrer dans le cadre de l'invention, il faut que le porte-écran 10 présente une structure ayant les deux caractéristiques suivantes:

- deux de ses côtés doivent être parallèles entre eux, par exemple les côtés C2 et C4, et

- chacun des deux montants 2, 4 délimitant ces deux côtés C2, C4 doit présenter deux surfaces planes opposées s'étendant sur toute la longueur du montant associé du porte-écran 10 et situées respectivement au niveau des deux faces principales opposées F1 et F2 du porte-écran 10; soit les surfaces S2, S'2 pour le montant 2 et S4, S'4 pour le montant 4.

En se référant plus particulièrement à la figure 2, le porte-écran 10 tel que défini précédemment est destiné à supporter un écran 12 sur lequel est prévu un motif à imprimer (non représenté). Cet écran 12 est par exemple tendu sur un cadre 13 lui-même rapporté sur l'une des faces principales F1 ou F2 du porte-écran 10 (soit F2 dans l'exemple illustré) et fixé sur ce dernier de façon à ce que l'écran 12 vienne en recouvrement de l'ouverture 11 du porte-écran 10. Dans l'esprit de l'invention le cadre 13 fait partie de la structure du porte-écran 10.

Le dispositif de positionnement conforme à l'invention se décompose en deux parties 20a, 20b situées respectivement au niveau du porte-écran 10 et au niveau de la machine de sérigraphie.

En se reportant toujours aux figures 1 à 4, la partie 20a du dispositif de positionnement du porte-écran 10 est essentiellement constituée de deux rainures 21, 22 et de deux butées 23, 24 respectivement logées dans les deux rainures 21, 22.

Les deux rainures 21, 22 rectilignes, à axes parallèles sont usinées respectivement dans les deux surfaces planes S2 et S4 des deux montants 2, 4 délimitant les deux côtés C2 et C4 du porte-écran 10. Ces deux rainures 21, 22 s'étendent parallèlement aux côtés C2 et C4, et ont chacune au moins une extrémité qui débouche vers l'extérieur d'un même côté du porte-écran 10. Dans l'exemple représenté, les deux rainures 21, 22 débouchent sur le côté C1 du porte-écran 10, côté dénommé ci-après côté avant, alors que le côté opposé C3 sera dénommé ci-après côté arrière du porte-écran 10.

Les deux butées 23, 24 sont logées respectivement dans les deux rainures 21, 22. La butée 23 est située dans la rainure 21 au voisinage du côté arrière C3 du porte-écran 10, alors que la butée 24 est située dans la rainure 22 au voisinage du côté avant C1 du porte-écran 10.

La butée 23, sous la forme d'un parallélépipède rectangle, a sa surface d'extrémité adjacente au côté avant C1 du porte-écran 10, qui présente une échancrure 25 en forme de V, alors que la butée 24, également sous la forme d'un parallélépipède rectangle, a sa surface d'extrémité adjacente au côté avant C1 du porte-écran 10, qui présente une section droite.

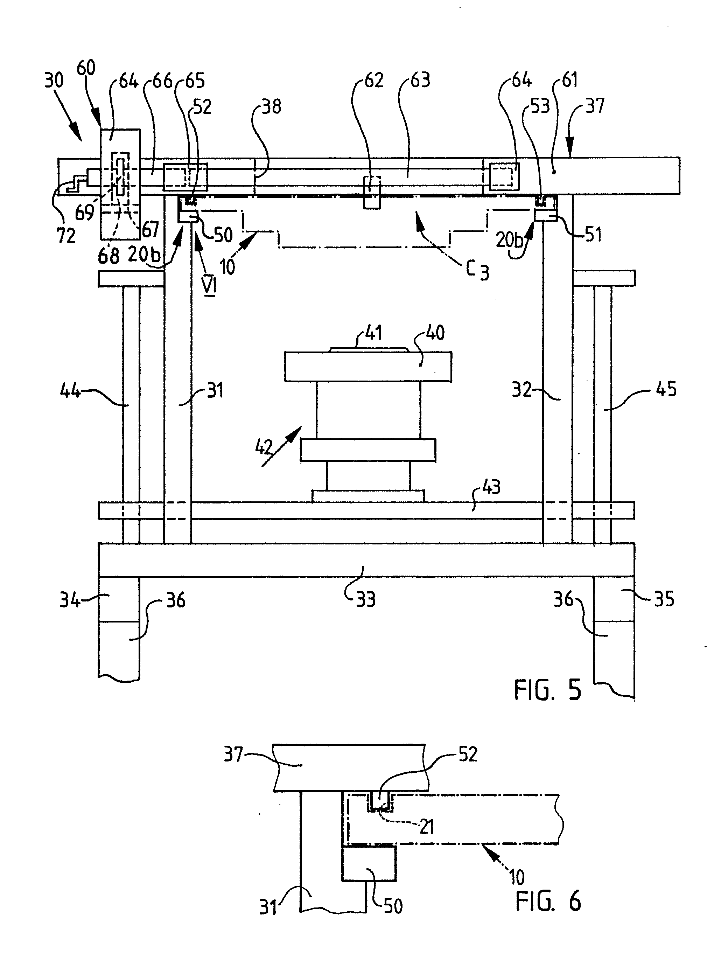

Chaque butée 23, 24 est maintenue en position par l'intermédiaire d'une vis 26 qui traverse un orifice 27 usiné suivant un axe perpendiculaire à l'axe de la rainure associé (figure 4).

Avant de décrire la seconde partie 20b du dispositif de positionnement du porte-écran au niveau de la machine de sérigraphie, il est nécessaire de décrire succinctement cette machine pour bien situer cette seconde partie 20b par rapport à la machine.

En se reportant à la figure 5, la machine de sérigraphie 30 comprend:

- un bâti formé de deux plaques latérales verticales 31, 32 fixées sur un socle 33 qui repose sur deux entretoises 34, 35 supportées par des pieds 36. Ces deux plaques verticales 31, 32 sont réunies ensemble, à leur extrémité supérieure, par une plaque d'appui horizontale 37 percée d'une ouverture centrale 38 sous laquelle l'écran de sérigraphie peut être placé en recouvrement,

- une platine 40 sur laquelle repose un substrat 41, la platine 40 étant fixée sur un bloc de positionnement 42, lui-même disposé sur une plaque horizontale 43 qui peut coulisser suivant une direction perpendiculaire à son plan le long de deux tiges verticales 44, 45 solidaires du bâti et s'étendant respectivement le long des plaques verticales 31, 32.

La partie 20b du dispositif de positionnement d'un porte-écran conforme à l'invention comprend au niveau de la machine de sérigraphie 30:

- deux glissières horizontales 50, 51 à axes parallèles s'étendant parallèlement aux plaques latérales 31, 32 du bâti de la machine 30, supportées respectivement par ces deux plaques 31, 32 et montées à un même niveau vers la partie supérieure de ces plaques et du côté intérieur du bâti de la machine 30,

- deux pions de référence 52, 53, à axe vertical, solidaires de la plaque horizontale 37 du bâti de la machine de sérigraphie 30, et faisant chacun saillie audelà de la surface inférieure de la plaque horizontale 37, l'entraxe entre ces deux pions de référence 52, 53 étant identique à l'entraxe des rainures 21, 22 du porte-écran 10, ces deux pions ayant un diamètre sensiblement inférieur à la largeur des rainures 21, 22 du porte-écran 10, et

- des moyens de blocage 60 pour bloquer en position le porte-écran 10 une fois celui-ci introduit dans la machine de sérigraphie 30.

Avant de décrire plus en détails ces moyens de blocage 60, il est préférable de décrire tout d'abord la phase de montage du porte-écran 10 dans la machine de sérigraphie 30 telle que représentée sur la figure 5.

Le porte-écran 10 est introduit par son côté avant C1 dans la machine de sérigraphie 30 en le faisant glisser le long des glissières 50, 51; la face principale F1 du porte-écran 10 devenant la face supérieure comprenant les rainures 21, 22, alors que la face principale F2 du porte-écran 10 devient la face intérieure sur laquelle a été rapporté l'écran 12. Au cours de ce mouvement les pions de référence 52, 53 du bâti de la machine de sérigraphie 30 respectivement alignés avec les rainures 21, 22 du porte-écran 10 vont pénétrer progressivement à l'intérieur de ces rainures.

Ce mouvement est interrompu dès que les butées 23, 24 logées respectivement dans les rainures 21, 22 viennent respectivement en contact avec les pions de référence fixes 52, 53 de la machine de sérigraphie 30.

Pour assurer un positionnement précis du porte-écran 10, il est important de noter le rôle joué par l'échancrure 25 en forme de V de la butée 23. Cette échancrure 25 a pour fonction de permettre un léger pivotement éventuel du porte-écran 10 dans son plan, lorsque le pion de référence 52 vient en contact avec la surface correspondante délimitée par l'échancrure 25 de la butée 23. Ce pivotement du porte-écran 10 a lieu uniquement lorsque l'axe de la rainure 21 n'est pas strictement aligné avec l'axe du pion de référence 52 pendant la phase de montage du porte-écran 10. Cela est généralement le cas du fait du léger jeu latéral qui existe entre les côtés C2 et C4 du porte-écran 10 et les plaques latérales 31, 32 du bâti qui délimitent avec les glissières 50, 51 et la plaque horizontale supérieure 37 du bâti de la machine, une ouverture dans laquelle est introduite le porte-écran 10. Le pivotement précité permet donc de centrer parfaitement le porte-écran 10, juste avant que la butée 24 logée dans la rainure 22 du porte-écran 10 vienne en contact avec le pion de référence 53 du bâti de la machine de sérigraphie 30 pour immobiliser le porte-écran 10.

Il est aisé de comprendre alors que le porte-écran 10 est bloqué vers l'avant, mais non bloqué vers l'arrière.

L'objet des moyens de blocage 60 précités est justement de bloquer le porte-écran 10 vers l'arrière.

Ces moyens 60 sont supportés par la surface d'extrémité 61 de la plaque horizontale 37 du bâti de la machine de sérigraphie 30, surface d'extrémité qui est adjacente au côté arrière C3 du porte-écran 10. Ces moyens sont donc situés à un niveau au-dessus de celui occupé par le porte-écran 10 dans la machine de sérigraphie 30. En effet, ces moyens ne peuvent pas être situés au même niveau que celui occupé par le porte-écran 10, du fait du mode d'introduction du porte-écran 10 dans la machine de sérigraphie 30.

Ces moyens 60 sont constitués par un taquet 62 solidaire d'un axe 63 mobile en rotation sous la commande d'un vérin 64 par exemple. L'axe 63 s'étend parallèlement au côté arrière C3 du porte-écran, avec une extrémité montée rotative dans un palier 64 porté par la surface d'extrémité 61 de la plaque horizontale 37, alors que son autre extrémité est mécaniquement accouplée par un dispositif 65 à un second axe 66 aligné avec l'axe 63. Le taquet 62 qui s'étend perpendiculairement à l'axe 63, est situé sur cet axe de façon à pouvoir venir en contact, après rotation avec le côté arrière C3 du porte-écran 10, sensiblement vers le milieu de ce côté C3. L'axe 66 en sortie du dispositif d'accouplement 65 est entraîné en rotation sous l'action du déplacement du piston 67 d'un vérin 64 dont le corps est porté par la surface d'extrémité 61 de la plaque 37 du bâti de la machine de sérigraphie 30. Selon un mode de réalisation, l'axe du vérin 64 est perpendiculaire à l'axe 66, le piston 67 du vérin 64 supportant une crémaillère 68 qui engrène un pignon 69 solidaire de l'extrémité libre de l'axe 66 qui pénètre à l'intérieur du corps du vérin 64.

Ainsi, sous la commande du vérin 64, le taquet 62 pivote pour venir exercer une force de pression sur le côté arrière C3 du porte-écran 10 et assurer son blocage en position en maintenant un contact positif entre les butées 23, 24 du porte-écran 10 et les pions de référence 52, 53 portés par le bâti de la machine de sérigraphie 30.

Les moyens de blocage 60 peuvent être complétés par des vérins (non représentés), à axe vertical, supportés par la plaque horizontale supérieure 37 du bâti de la machine de sérigraphie 30, et dont la fonction est d'appliquer une force de pression sur la face supérieure F1 du porte-écran 10, afin de le plaquer sur les glissières 50, 51. Dans l'exemple illustré, l'axe 66 se prolonge par un levier coudé 72 solidaire en rotation de l'axe 66, et qui a pour fonction, une fois le taquet 62 en position de contact avec le côté arrière C3 du porte-écran 10, d'actionner un contact qui commande la mise sous pression des vérins précités.

Ensuite, une fois le substrat 41 correctement positionné sur la platine 40, cette dernière est soulevée pour amener le substrat 41 à proximité immédiate de l'écran 12 pour effectuer l'opération de dépôt d'une couche sur ce substrat 41, comme cela est décrit en détail dans la demande de brevet français précitée de la demanderesse.

En se reportant à la figure 2 et sans sortir du cadre de l'invention, la rainure 21 peut être située du côté de la face F1 du porte-écran 10 et la rainure 22 située du côté de la face F2 du porte-écran 10, et inversement.

Il est évident également que, tout en restant parallèles, les deux montants 2 et 4 ne sont pas obligatoirement dans un même plan.

En se reportant à la figure 1, les quatre orifices 110 qui traversent le porte-écran 10 servent au montage de l'écran 12 sur le porte-écran 10, orifices dans lesquels passent des moyens de fixation réglables.

Sans sortir également du cadre de l'invention, un tel dispositif de positionnement et de blocage peut être appliqué à des machines de sérigraphie pour la fabrication d'autres produits que des supports de circuits de connexions à couches épaisses.

## Revendications

1. Machine de sérigraphie pour la fabrication de supports de circuits de connexions à couches épaisses, comprenant: un bâti (31, 32); un porte-écran (10) fait de quatre montants (1–4), dont deux montants latéraux parallèles (2, 4), formant un cadre délimitant une ouverture (11); un écran (12) rapporté sur une face (F2) du porte-écran (10) en recouvrement de l'ouverture (11); un dispositif de positionnement (20a 20b) du porte-écran (10) par rapport au bâti, incluant deux pions de référence (52, 53) fixes et verticaux, solidaires du bâti et coopérant avec deux cavités correspondantes du porte-écran; et un dispositif (60) de blocage en position finale du porte-écran dans la machine; caractérisée en ce que dans le dispositif de positionnement (20a, 20b): deux glissières (50, 51) horizontales, portées par le bâti (31, 32) et parallèles aux deux montants latéraux (2–4), forment un support coulissant pour ces deux montants pour introduire le porte-écran (10) dans la machine; les deux cavités sont deux rainures (21, 22) parallèles usinées respectivement dans les deux montants latéraux (2, 4) du porte-écran (10) parallèlement à ces deux montants et débouchant d'un même côté (C1) du porte-écran; les deux pions de référence (52, 53) ont un diamètre sensiblement inférieur à la largeur des rainures, pénètrent progressivement à l'intérieur des deux rainures respectives (21, 22) et sont décalés dans la direction des montants latéraux (2, 4) de façon que l'une des rainures puis les deux rainures servent de guidage pour l'introduction du porte-écran; et deux butées (23, 24), l'une à face droite et l'autre à face en V, sont montées dans les deux rainures (21, 22) en étant décalées à l'égal des deux pions (52, 53) pour le positionnement final du porte-écran dans la machine.

2. Machine selon la revendication 1, caractérisée en ce que les moyens de blocage (60) comprennent un taquet (62) solidaire d'un axe (63) parallèle au montant arrière (3) du porte-écran et mobile en rotation parallèlement au plan de ce dernier pour dégager le taquet lors de l'introduction du porte-écran.

## Claims

1. Screen-printing machine for the production of supports for circuits comprising thick-layer connections, comprising: a framework (31, 32); a screen-carrier (10) formed by four stiles (1–4) of which two parallel side stiles (2, 4) form a frame delimiting an aperture (11); a screen (12) bearing on one surface (F2) of the screen-carrier (10) covering the aperture (11); a device (20a, 20b) for positioning the screen carrier (10) with respect to the framework, including two reference dowels (52, 53) which are fixed and vertical, integral with the framework and cooperating with two corresponding recesses of the screen-carrier; and a device (60) for locking the screen-carrier in its final position in the machine; characterised in that in the positioning device (20a, 20b): two horizontal sideways (50, 51), carried by the framework (31, 32) and parallel to the two side stiles (2–4), form a sliding support for these two stiles for insertion of the screen-carrier (10) into the machine; the two recesses are two parallel grooves (21, 22) machined respectively into the two side stiles (2, 4) of the screen-carrier (10) parallel to these two stiles and opening at one and the same side (C1) of the screen-carrier; the two reference dowels (52, 53) have a diameter substantially smaller than the width of the grooves, penetrate progressively within the two respective grooves (21, 22) and are offset in the direction of the side stiles (2, 4) in such manner that the one of the grooves and then both grooves act as guides for the insertion of the screen-carrier; and two stops (23, 24) of which one has a flat end face and the other a Vee end face, are disposed in the two grooves (21, 22) whilst being offset equally with the two dowels (52, 53) for the final positioning of the screen-carrier in the machine.

2: Machine according to claim 1, characterised in that the locking means (60) comprise a block (62) fixed with a spindle (63) parallel to the rear stile (3) of the screen-carrier and movable in rotation parallel to the plane of this latter to free the block upon inserting the screen-carrier.

**Patentansprüche**

1. Siebdruckmaschine zur Herstellung von Trägern für Dickschicht-Verbindungsschaltungen, enthaltend: Ein Gestell (31, 32); einen Schirmträger (10), der aus vier Stützen (1–4) gebildet ist, wovon zwei parallele seitliche Stützen (2, 4) einen Rahmen bilden, welcher eine Öffnung (11) begrenzt; einen Schirm (12), der auf eine Fläche (F2) des Schirmträgers (10) aufgesetzt ist und die Öffnung (11) abdeckt; eine Vorrichtung (20a, 20b) zur Positionierung des Schirmträgers (10) bezüglich des Gestells, versehen mit zwei feststehenden senkrechten Bezugszapfen (52, 53), die mit dem Gestell fest verbunden sind und mit zwei entsprechenden Hohlräumen des Schirmträgers zusammenwirken, und eine Vorrichtung (60) zur Blockierung in der Endstellung des Schirmträgers in der Maschine, dadurch gekennzeichnet, dass in der Positioniervorrichtung (20a, 20b) zwei waagrechte, vom Gestell (31, 32) getragene und zu den zwei seitlichen Stützen (2–4) parallele Schiebebahnen einen verschiebbaren Träger für die zwei Stützen bilden, um den Schirmträger (10) in die Maschine einzuführen; wobei die zwei Hohlräume zwei parallele Nuten (21, 22) sind, welche jeweils in einer der zwei seitlichen Stützen (2, 4) des Schirmträgers (10) parallel zu diesen Stützen angebracht sind und auf derselben Seite (C1) des Schirmträgers münden; wobei die zwei Bezugszapfen (52, 53) einen Durchmesser aufweisen, der beträchtlich kleiner als die Breite der Nuten ist, und progressiv in die entsprechenden Nuten (21, 22) eindringen sowie in der Richtung der seitlichen Stützen (2, 4) derart versetzt sind, dass eine der Nuten und anschliessend die zwei Nuten als Führung für das Einschieben des Schirmträgers dienen; und zwei Anschläge (23, 24), von denen der eine eine gerade Fläche und der andere eine V-Fläche aufweist, in den zwei Nuten (21, 22) derart angebracht sind, dass sie in gleicher Weise wie die zwei Zapfen (52, 53) für die endgültige Positionierung des Schirmträgers in der Maschine versetzt sind.

2. Maschine nach Anspruch 1, dadurch gekennzeichnet, dass die Blockiermittel (60) ein Ansatzteil (62) umfassen, welches fest mit einer Achse (63) verbunden ist, die parallel zur rückseitigen Stütze (3) des Schirmträgers verläuft und parallel zur Ebene desselben drehbeweglich ist, um das Ansatzteil bei der Einführung des Schirmträgers zu lösen.

FIG. 1

FIG. 2

FIG. 3

FIG. 4

FIG. 5

FIG. 6